# EUROPEAN PATENT SPECIFICATION

(11) **EP 2 208 805 B1**
(45) Date of publication and mention of the grant of the patent: **02.03.2016**
(21) Application number: 09252892.6
(22) Date of filing: 23.12.2009
(51) Int. Cl.: C23C 16/04, C23C 16/16, C23C 30/00, F01D 25/00, C23C 14/04, C23C 14/16, C23C 14/22

(54) **Strain tolerant thermal barrier coating system**
Dehnungstolerantes Wärmedämmbeschichtungssystem
Système de revêtement à barrière thermique tolérant en contrainte

(30) Priority: 24.12.2008 US 343529
(43) Date of publication of application: 21.07.2010
(73) Proprietor: United Technologies Corporation, Hartford, CT 06103 (US)
(72) Inventor: Litton, David A., West Hartford CT 06107 (US); Schlichting, Kevin W., South Glastonbury, CT 06073 (US); Maloney, Michael J., Marlborough, CT 06447 (US); Freling, Melvin, West Hartford CT 06117 (US)
(74) Representative: Hall, Matthew Benjamin

(56) References cited:
- EP-A1- 0 992 603
- EP-A2- 1 927 673
- US-A1- 2006 257 688

## Description

The present invention relates to a coating system for a nickel based superalloy component such as a combustor panel, a fuel nozzle, and/or a bulkhead heat shield.

Combustor panels and fuel nozzles are commonly employed in gas turbine engines. These turbine engine components in use develop hotspots. Excessive oxidation and cracking at these hotspots can lead to a shortened service life for these components.

In the past, an equiaxed nickel based superalloy has usually been used to form these components. Onto the component, an oxidation resistant metallic bondcoat (usually a NiCoCrAlY) was plasma sprayed under inert gas shrouding. The bondcoat was covered by a ceramic thermal insulating layer consisting of doped zirconia which was sprayed onto the bondcoat using air plasma spraying (APS). The coating deposited in the foregoing manner has a low thermal conductivity since the plasma spray process can be parameterized to produce porosity that is oriented predominantly perpendicular to the direction of the flow of heat through the coating. One would expect that the reduction in thermal conductivity would be the primary driver for the durability of combustor panels coated in this fashion, since the low thermal conductivity would translate to lower metal temperature, thus slower stress buildup in the coating, thus longer coating life, thus longer part life. However, it turned out that due to the nature of heat transfer in combustors, there are local hotspots on the combustor panels that run significantly hotter than the average temperature of the part. The hotspots can be so hot that they result in sintering of the prior art plasma sprayed insulating coatings. Once sintering occurs, the stress buildup in the coating is accelerated, and the life of the coating is significantly shortened. Once the coating is lost, the life of the part is significantly shortened.

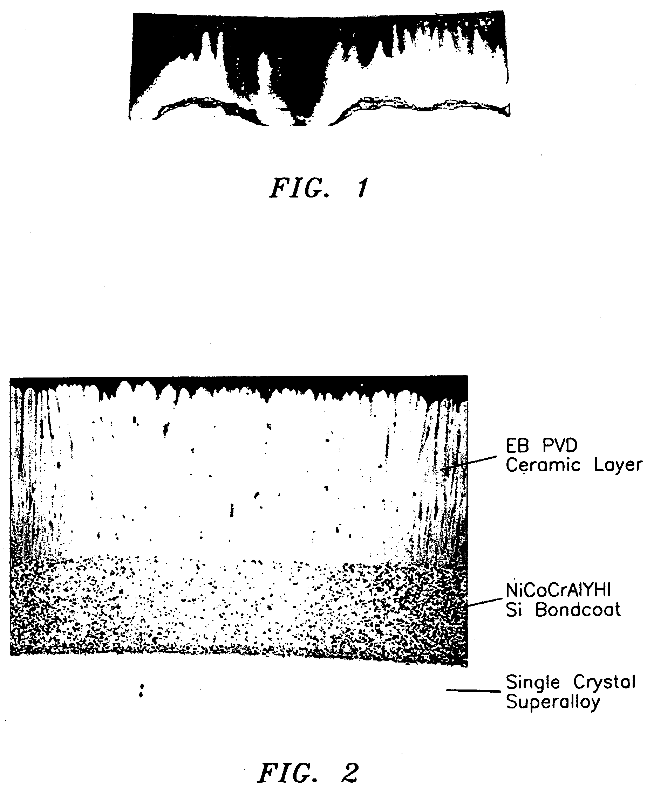

In other words, the thermal capability of these prior systems however could be exceeded during use. After sufficient exposures at sufficiently high temperatures, the stresses at the interface between the thermal barrier coating (TBC) and the bondcoat become too great, thus leading to the spallation of the thermal barrier coating. Since the thermal barrier coating is thermally insulating, this leads to a significant increase in the temperature of the metallic coating and the superalloy, local to the coating spall. Also due to the large temperature gradient that results locally, thermal fatigue is enhanced at or near TBC spalls, leading to cracking of the superalloy. The result is loss of some portion of the combustor panel by oxidation as well as cracking and liberation. Figure 1 illustrates a severely oxidized combustor panel after being removed from aeroengine service.

Exemplary prior thermal barriers for gas turbine engines are disclosed in EP 0992603, US 2006/0257688 and EP 1927673.

A thermal barrier coating system is described herein which provides better resistance to sintering than the aforementioned thermal barrier coatings.

Viewed from a first aspect, the present invention provides an engine component comprising a substrate selected from the group consisting of a combustor panel, a bulkhead heat shield, and a fuel nozzle, said substrate being formed from a single crystal superalloy, a metallic bondcoat layer formed from a gamma-gamma prime bond coating, wherein said gamma-gamma prime bond coating has a gamma prime phase present in a volume fraction of from 0.6 to 0.95 and a gamma phase present in a fraction of from 0.05 to 0.4, and a ceramic composition coating applied over said substrate, said ceramic composition coating having a columnar microstructure, wherein said gamma-gamma prime bond coating has a composition in wt% consisting of from 5.0 to 18% chromium, 7.5 to 12% aluminum, up to 15% cobalt, up to 10.0% tantalum, up to 10% molybdenum, up to 6.0% rhenium, up to 5.0% tungsten, up to 1.0% yttrium, from 0.06 to 0.5% hafnium, up to 0.3% silicon, and the balance nickel.

Viewed from a second aspect, the present invention provides a method for forming a thermal barrier coating comprising the steps of: providing a component selected from the group consisting of a combustor panel, a bulkhead heat shield, and a fuel nozzle; depositing a first layer of a gamma-gamma prime bond coating, wherein said gamma-gamma prime bond coating has a gamma prime phase present in a volume fraction of from 0.6 to 0.95 and a gamma phase present in a fraction of from 0.05 to 0.4 onto said component, and wherein said gamma-gamma prime bond coating has a composition in wt% consisting of from 5 to 18% chromium, 7.0 to 12% aluminum, up to 15% cobalt, up to 10.0% tantalum, up to 10% molybdenum, up to 6.0% rhenium, up to 5.0% tungsten, up to 1.0% yttrium, from 0.06 to 0.5% hafnium, up to 0.3% silicon, and the balance nickel; and depositing a ceramic composition layer using an electron beam physical vapor deposition technique wherein said ceramic composition depositing step comprises maintaining said component in a chamber at a pressure in the range of 1e-5 to 1e-3 Torr (1.33 x 10⁻³ to 133 Pa), applying a partial oxygen pressure in the range of 1e-5 to 1e-3 Torr (1.33 x 10⁻³ to 133 Pa), maintaining an electron beam current in the range of 1.0 to 5.0 amps onto a source material contained in a crucible, maintaining component temperature within the range of from 1800 degrees Fahrenheit to 2100 degrees Fahrenheit (982 - 1149°C), feeding an ingot of said source material into said crucible at a rate of 0.5 to 2.0 inches per hour (12.7 to 51 mm per hour), and maintaining a deposition rate of 1.0 to 5.0 microinches per second (25.4 to 127 nm per second).

Certain preferred embodiments of the present invention will now be described in greater detail, by way of example only, and with reference to the accompanying figures, in which:
Figure 1 illustrates a severely oxidized combustor panel after being removed from aeroengine service;
Figure 2 is a photograph of the cross section of one exemplary coating system at a magnification of about 100X; and
Figures 3(a) through 3(f) illustrate elemental maps showing CMAS penetration into a PWA265 combustor coating and reduced penetration into a gadolinia stabilized zirconia EB-PVD combustor coating.

A strain tolerant thermal barrier coating system as described herein consists of a first metallic bondcoat layer that is deposited onto a substrate, such as a combustor panel, a bulkhead heat shield, and/or a fuel nozzle, formed from a single crystal nickel based superalloy. The first layer may be formed using plasma spraying under vacuum conditions or by cathodic arc deposition also under vacuum conditions. Other processes which may be used for depositing the first bondcoat layer include electroplating, pack diffusion coating, over-the-pack diffusion coating, chemical vapor deposition, thermal evaporation, electron beam physical vapor deposition, directed vapor deposition, and combinations thereof.

The bondcoat layer is formed from a predominantly two phase γ/γ' NiCoCrAlYHfSi coating, with and without a platinum addition.

Assuming the volume fraction of the gamma prime phase is X, the volume fraction of the gamma phase is predominantly 1 - X. The range of X of the gamma prime phase may be from 0.6 to 0.95 for the metallic bond coating in the as-processed state, with a particularly useful range of X being from 0.7 to 0.9.

The range of the gamma phase is from 0.05 to 0.4 with a particularly useful range being from 0.1 to 0.3.

The composition of the two phase γ/γ' NiCoCrAlYHfSi, in wt%, consists of from 5.0 to 18% chromium, 7.5 to 12% aluminum, up to 15% cobalt, up to 10.0% tantalum, up to 10% molybdenum, up to 6.0% rhenium, up to 5.0% tungsten, up to 1.0% yttrium, from 0.06 to 0.5% hafnium, up to 0.3% silicon, and the balance nickel.

After a first bondcoat layer is deposited, it may be further densified by peening, and then polished using attritor milling or grit blasting.

The first bondcoat layer may be processed to maximize the density of the as-processed coating and to minimize the presence of any oxide phases within the metallic layer. The maximum density in the bondcoat may be achieved in different ways for different deposition techniques. For plasma spraying, maximum density may be achieved by spraying in a vacuum (a/k/a vacuum plasma spraying or low pressure plasma spraying); diffusing the metallic bond coat in a protective atmosphere (i.e. argon or vacuum) at 1800 to 2000 degrees Fahrenheit (982-1093°C) for 2.0 to 10 hours, and densifying the coating by peening.

For high velocity oxygen fuel (HVOF) deposition, maximum density may be achieved by spraying in air using HVOF, diffusing the metallic bond coat in a protective atmosphere (i.e. argon or vacuum) at 1800 to 2000 degrees Fahrenheit (982-1093°C) for 2.0 to 10 hours, and peening the metallic coating.

For cathodic arc deposition, maximum density may be achieved by physical vapor deposition of the metallic bond coat in a vacuum chamber, diffusing the metallic bond coat in a protective atmosphere (i.e. argon or vacuum) at 1800 to 2000 degrees Fahrenheit (982-1093°C) for 2.0 to 10 hours, and peening the metallic coating.

A second layer or thermal barrier layer is then deposited on the bondcoat. The second layer may consist of a ceramic composition with low thermal conductivity, i.e. a composition having a conductivity in the range of from 6.0 to 15 BTU in/hr ft² °F (0.86 to 2.16 W/mK). Typical compositions of the second layer, which is a thermal barrier layer, include doped ZrO₂, CeO₂, HfO₂, or mixtures thereof. The dopants may include yttrium, indium, scandium, and the lanthanide series of metallic elements on the periodic table of elements (La through Lu) - namely, lanthanum, cerium, praseodymium, neodymium, promethium, samarium, europium, gadolinium, terbium, dysprosium, holmium, erbium, thulium, ytterbium, and lutetium. Dopant levels may range from 2.0 mol% to 50 mol%. The ceramic thermal barrier layer is deposited using an electron beam physical vapor deposition process.

Optionally, a third or fourth layer, consisting of the ceramic described above, could be applied such that the composite properties can be achieved by layering.

If desired, one can use a ceramic interlayer. This can be done by applying a metallic bond coat of the type described hereinabove, applying a ceramic interlayer over the metallic bond coat, and then applying a low conductivity layer. The ceramic interlayer may a composition having a conductivity in the range of from 10 to 16 BTU in/hr ft² °F (1.44-2.31 W/mK). Typical compositions of the second layer, which is a thermal barrier layer, include doped zrO₂, CeO₂, HfO₂, or mixtures thereof. The dopants may include yttrium, indium, scandium, and the lanthanide series of metallic elements on the periodic table of elements (La through Lu) - namely, lanthanum, cerium, praseodymium, neodymium, promethium, samarium, europium, gadolinium, terbium, dysprosium, holmium, erbium, thulium, ytterbium, and lutetium. Dopant levels may range from 3.0 mol% to 9.0 mol%. The ceramic interlayer may be deposited using an electron beam physical vapor deposition process. Other processes which may be used to form the ceramic interlayer include directed vapor deposition, low pressure plasma spray - thin film, chemical vapor deposition, sol-gel processing, reactive sputtering, reactive cathodic arc processing, or electrophoretic deposition.

The deposition process should create the thermal barrier coating by condensation of vapor molecules, atoms or ions; reaction between vapor molecules and the solid surface of the substrate; or precipitation from solution. The deposition process usefully creates a coating with a columnar microstructure. This can be achieved in electron beam physical vapor deposition (EB-PVD), for example, by keeping the temperature of the solid surface low enough to limit surface diffusion of condensing vapor molecules. This results in columnar growth since there is insufficient diffusion to fill the gaps between growing nuclei. At the same time, the temperature of the solid surface must be kept high enough to ensure sufficient diffusion within the growing nuclei to fill voids within the columns to avoid excessive porosity, and to ensure vertical growth of the columns. If the temperature of the solid surface is too low, the columns grow with a more conical morphology that is excessively porous, leading to reduced strain tolerance, and reduced resistance to erosion and sintering. These reduced properties reduce the durability of the coating in an engine environment.

EB-PVD has been surprisingly found to be a particularly useful process for forming the second layer described herein. EB-PVD deposition allows the formation of a columnar deposit which has a higher in-plane strength and a higher in-plane tolerance which enables the deposit to withstand more load than an APS deposit. Further, EB-PVD deposited coatings better resist CMAS induced distress. The columnar deposit provides strength even though there is some CMAS penetration. The CMAS typically only partially infiltrates the deposited coating since it reacts with the columns to form a barrier layer that resists further infiltration. Thus, there is much less acceleration of damage accumulation in the EB-PVD deposited coating. In comparison, thermal spray deposits are porous and formed in planar layers with boundaries there between. The deposits lack strength in the boundaries and are brittle and prone to delamination. Due to their porosity, the CMAS often fully infiltrates the coating.

To perform EB-PVD deposition of the second layer, the parameters are as follows: the chamber pressure is in the range of 1e-5 Torr to 1e-3 Torr (1.33 x 10⁻³ to 1.33 x 10⁻¹ Pa); the partial pressure of oxygen is the same as the chamber pressure and may be accomplished by flowing oxygen during coating; the deposition rate is in the range of 1.0 to 5 microinches per second (25-127 nm/s)with a range of from 2.5 to 3.0 microinches per second (63.5 - 76 nm/s) being particularly useful; and the temperature of the substrate being coated is from 1800 to 2100 degrees Fahrenheit (982-1149°C). The aforementioned temperature range and the partial pressure are critical to the formation of the desired columnar structure. If the temperature is too low, then the deposit lacks the claimed columnar structure and is more of a deposit that many small cauliflower shaped particles. If the temperature is too high, the deposit becomes equiaxed.

The deposition rate is be accomplished by directing an electron beam current of from 1.0 to 5.0 amps onto the source material that may be contained in a crucible, and maintaining the current in the above ranges. This causes the source material to melt, forming a pool of liquid melt. The height of the melt pool may be kept constant in the crucible, by continuously feeding material into the crucible. One means to do this is to continuously feed an ingot into the crucible (from the bottom of the crucible). For a 2.0 to 6.0 inch (51 to 152 mm) diameter ingot., the ingot feed rate is from 0.5 to 2.0 inches per hour 12.7-51 mm per hour.

The deposition process may be enhanced by varying the above mentioned parameters using the design of experiments methodology, then testing the coatings that are produced by cyclic oxidation testing (such as furnace cycling or burner rig cycling) to determine the cyclic spallation life of the coatings. Maximum life in these tests correlates to optimal deposition processes.

A photograph of the cross section of one exemplary system that is outside the scope of the claims is shown at a magnification of about 100X in Figure 2. This system consists of a single crystal superalloy onto which a NiCoCrAlYHfSi two phase β/γ metallic bondcoat was deposited by vacuum plasma spraying. The metallic bondcoat layer was heat treated to bond it to the superalloy, then peened and polished. Finally a 7 wt% yttrium doped zirconia ceramic thermal barrier layer was deposited onto the bondcoat using EB-PVD.

If reactive element doped single crystal superalloys, such as a superalloy consisting essentially of, by weight percent, 4.0 - 7.5% chromium, 8.0 to 12% cobalt, 0.5 to 2.5% molybdenum, 3.5 to 7.5% tungsten, 2.5 to 4.0% rhenium, 8.0 to 10% tantalum, 5.0 to 6.0% aluminum, 0.05 to 0.5% hafnium, 0.005 to 0.054% yttrium or oxygen active elements, and the balance nickel are used as the base alloy for the substrate, i.e. combustor panel, fuel nozzle, or bulkhead heat shield, the first bondcoat layer can be omitted, such that the ceramic thermal barrier can be deposited directly on a surface of the substrate formed from the superalloy.

The combination of a dense, smooth, oxide-free bondcoat (or a bare Y-enriched second generation single crystal superalloy) and the strain-tolerant columnar thermal barrier layer creates a thermal barrier coating system for substrates, such as combustor panels and fuel nozzles, that is more durable with respect to cyclic engine service. Specifically, the smooth interface between the ceramic layer and the bondcoat layer, or the advanced superalloy, minimizes the stresses that build up at the interface over the thousands of cycles of a typical run interval of an aeroengine. Furthermore, the columnar microstructure of the EB-PVD coatings are more strain-tolerant than APS coatings, thus they are more robust to the stresses that do develop at the interface. Thus, the thermal barrier coating system described herein enables a combustor to be run hotter without increasing the rate of damage accumulation of combustor panels and fuel nozzles. Running the combustor hotter results in higher engine performance or efficiency.

Although thermal barrier coatings have been applied to turbine hardware, it is surprising that significant benefits can be obtained by applying a thermal barrier coating such as that described herein to combustor panels and fuel nozzles. The reasons for these surprising benefits are as follows.

Since coatings produced by vapor deposition have better sintering resistance, the presence of hotspots does not accelerate stress buildup and coating loss nearly as much. This is despite the fact that the metal temperature beneath the second (insulating ceramic) layer is higher for the vapor deposited coatings. The result is a surprisingly longer part life for parts coated with vapor deposited coatings than for parts with plasma sprayed coatings.

A second advantage is as follows. Vapor deposited coatings are more CMAS resistant. CMAS stands for calcium magnesium aluminum and silicon and is a catch-all term for the chemistry of deposits that form on top of the topcoat of thermal barrier coating systems during engine operation. If deposits form on the coating due to ingested dirt impacting the combustor panels and sticking to the coating surface, the deposits will melt if the temperature of the coating surface is high enough (typically greater than 2200 degrees Fahrenheit (1205°C)).

Thermally sprayed coatings form by deposition of liquid droplets impinged on the component or part. The droplets freeze on hitting the part, forming what is termed as "splats", which are very roughly disc shaped. Thus, the microstructure of the coating consists of randomly stacked splats, which are comparable to randomly stacked pancakes. If this molten CMAS forms on plasma sprayed coatings, it wets the boundaries between the splats, and tends to attack and dissolve the bonds between the splats. Thus, CMAS-attacked thermally sprayed coatings tend to flake off from the surface downward, relatively quickly, until the coating is gone. This dramatically reduces part life. Since combustor panels have hotspots, this distress tends to happen in the hotspots, leading to exposed bare spots on the parts. This also leads to large thermal gradients in the parts, (since areas of the part that were exposed by loss of coating are running much hotter than the rest of the part). These thermal gradients lead to thermomechanical fatigue cracking, which further shortens the life of the parts.

The microstructures of vapor deposited coatings can be parameterized to be columnar, primarily by controlling the temperature of the part being coated to between 0.39 Tₘ, coating and 0.43 Tₘ, coating where Tₘ, coating refers to the melting point of the material being coated. This columnar microstructure results in a coating that has significant strength along the long axes of the columns, but, due to the gaps between columns, has great compliance or strain-tolerance in the plane of the coating. Since the coatings are strong along the length of the columns, molten CMAS does not result in rapid flaking off of the coating from the top down. This makes the columnar microstructure of vapor deposited coatings more durable than the stacked splat microstructure of thermally sprayed coatings, with respect to CMAS.

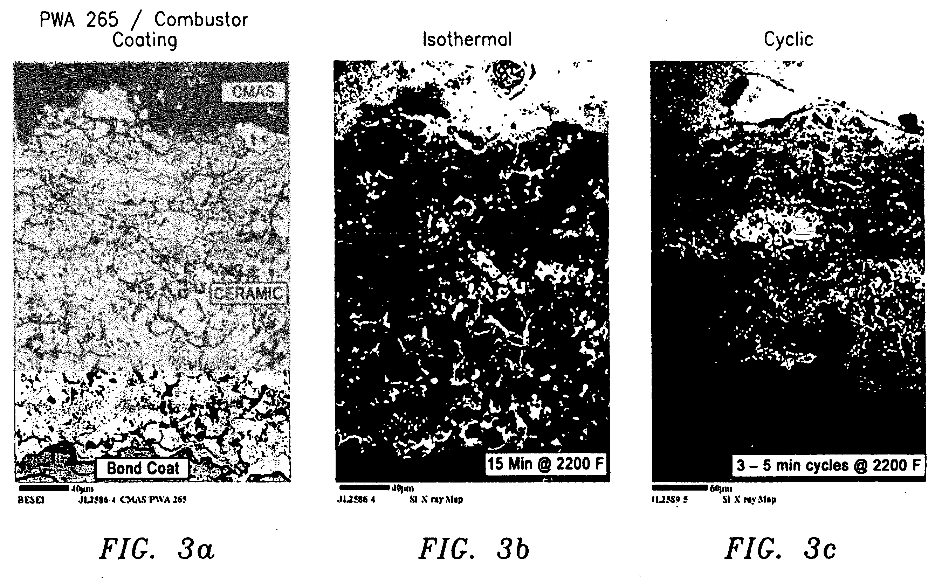

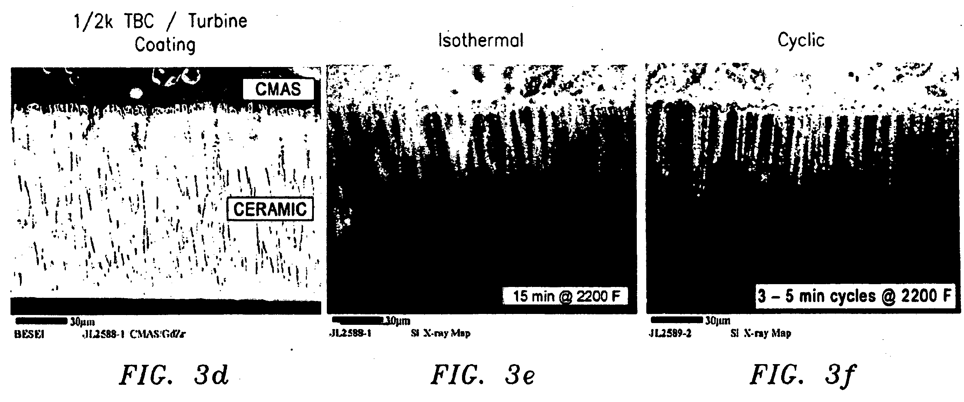

This benefit was demonstrated in the laboratory by performing molten dirt/sand testing. Dirt and/or sand ingested into the gas turbine engine is typically made up of a mixture of calcium, magnesium, aluminum, and silicon oxides or sulfates and is typically termed CMAS. When this mixture is heated, it forms a low melting eutectic compound which infiltrates and attacks the thermal barrier coating. A low conductivity doped stabilized zirconia EB-PVD coating has shown a greater resistance to penetration of this CMAS than the current APS combustor coating. Furnace test results are shown in Figures 3(a) - 3(f). Figures 3(a) and 3(d) show the optical photo of the coatings in cross section. The first coating shown in Figure 3(a) is a typical air plasma sprayed combustor coating. The second coating shown in Figure 3(d) is a coating formed as described herein with a low conductivity doped stabilized zirconia EB-PVD coating layer applied to a combustor panel. Figures 3(b), (c), (e), and (f) are chemical maps of silicon for an isothermal exposure at 2200 degrees Fahrenheit (1205°C) for 15 minutes and a cyclic exposure of three five minute cycles at 2200 degrees Fahrenheit (1205°C) respectively. As can be seen from the photos, silicon penetrates 80 to 100% of the combustor coating shown in Figure 3(a), while the low conductivity doped coating in Figure 3(d) shows approximately 33% penetration.

The coatings described herein are different in that they are the first application of a low conductivity doped stabilized zirconia EB-PVD coating to a combustor panel, the first application of a CMAS resistant thermal barrier coating to a combustor panel, and the first application of an EB-PVD type coating to a combustor panel.

In accordance with the present disclosure, there has been provided a strain tolerant thermal barrier coating for combustor panels and fuel nozzles.

## Claims

1. An engine component comprising a substrate selected from the group consisting of a combustor panel, a bulkhead heat shield, and a fuel nozzle, said substrate being formed from a single crystal superalloy, a metallic bondcoat layer formed from a gamma-gamma prime bond coating, wherein said gamma-gamma prime bond coating has a gamma prime phase present in a volume fraction of from 0.6 to 0.95 and a gamma phase present in a fraction of from 0.05 to 0.4, and a ceramic composition coating applied over said substrate, said ceramic composition coating having a columnar microstructure,
wherein said gamma-gamma prime bond coating has a composition in wt% consisting of from 5.0 to 18% chromium, 7.5 to 12% aluminum, up to 15% cobalt, up to 10.0% tantalum, up to 10% molybdenum, up to 6.0% rhenium, up to 5.0% tungsten, up to 1.0% yttrium, from 0.06 to 0.5% hafnium, up to 0.3% silicon, and the balance nickel.

2. The engine component of claim 1, wherein said substrate is a combustor panel.

3. The engine component of claim 1, wherein said substrate is a fuel nozzle.

4. The engine component of claim 1, wherein said substrate is a bulkhead heat shield.

5. The engine component according to claim 1, wherein said gamma-gamma prime bond coating has a gamma prime phase present in a volume fraction of from 0.7 to 0.9 and a gamma phase present in a fraction of from 0.1 to 0.3.

6. The engine component according to any preceding claim, wherein said ceramic composition layer comprises an oxide selected from the group consisting of zirconia, ceria, hafnia, and mixtures thereof doped with from 2 mol% to 50 mol% of a dopant selected from the group consisting of yttrium, indium, scandium, lanthanum, cerium, praseodymium, neodymium, promethium, samarium, europium, gadolinium, terbium, dysprosium, holmium, erbium, thulium, ytterbium, and lutetium.

7. A method for forming a thermal barrier coating comprising the steps of:
providing a component selected from the group consisting of a combustor panel, a bulkhead heat shield, and a fuel nozzle;
depositing a first layer of a gamma-gamma prime bond coating, wherein said gamma-gamma prime bond coating has a gamma prime phase present in a volume fraction of from 0.6 to 0.95 and a gamma phase present in a fraction of from 0.05 to 0.4 onto said component, and wherein said gamma-gamma prime bond coating has a composition in wt% consisting of from 5 to 18% chromium, 7.0 to 12% aluminum, up to 15% cobalt, up to 10.0% tantalum, up to 10% molybdenum, up to 6.0% rhenium, up to 5.0% tungsten, up to 1.0% yttrium, from 0.06 to 0.5% hafnium, up to 0.3% silicon, and the balance nickel; and
depositing a ceramic composition layer using an electron beam physical vapor deposition technique wherein said ceramic composition depositing step comprises maintaining said component in a chamber at a pressure in the range of 1e-5 to 1e-3 Torr (1.33 x 10⁻³ to 133 Pa), applying a partial oxygen pressure in the range of 1e-5 to 1e-3 Torr (1.33 x 10⁻³ to 133 Pa), maintaining an electron beam current in the range of 1.0 to 5.0 amps onto a source material contained in a crucible, maintaining component temperature within the range of from 1800 degrees Fahrenheit to 2100 degrees Fahrenheit (982 - 1149°C), feeding an ingot of said source material into said crucible at a rate of 0.5 to 2.0 inches per hour (12.7 to 51 mm per hour), and maintaining a deposition rate of 1.0 to 5.0 microinches per second (25.4 to 127 nm per second).

8. The method according to claim 7, wherein said first layer depositing step further comprises depositing said gamma-gamma prime bond coating with the gamma prime phase being present in a volume fraction of from 0.7 to 0.9 and the gamma phase is present in a fraction of from 0.1 to 0.3.

9. The method according to claim 7 or 8, further comprising depositing said first layer, densifying the first layer by peening, and polishing the densified first layer, wherein said densifying step comprises diffusing the first layer in a protective atmosphere selected from the group consisting of argon and a vacuum at a temperature in the range of from 1800 to 2000 degrees Fahrenheit (1093°C) for 2.0 to 10 hours, and densifying the coating by peening.

10. The method according to any of claims 7 to 9, wherein said component providing step comprises providing a combustor panel formed from a single crystal nickel based superalloy.

11. The method according to any of claims 7 to 10, wherein said ceramic composition layer depositing step comprises depositing an oxide selected from the group consisting of zirconia, ceria, hafnia, and mixtures thereof doped with from 2 mol% to 50 mol% of a dopant selected from the group consisting of yttrium, indium, scandium, lanthanum, cerium, praseodymium, neodymium, promethium, samarium, europium, gadolinium, terbium, dysprosium, holmium, erbium, thullium, ytterbium, and lutetium.

## Patentansprüche

1. Motorkomponente, umfassend ein Substrat, ausgewählt aus der Gruppe bestehend aus einer Brennkammerplatte, einem Trennwandhitzeschild und einer Brennstoffdüse, wobei das Substrat aus einer Einkristallsuperlegierung, einer metallischen Haftvermittlerschicht, die aus einer Gamma-Gamma-Prime-Haftbeschichtung gebildet ist, wobei die Gamma-Gamma-Prime-Haftbeschichtung eine Gamma-Prime-Phase, die in einer Volumenfraktion von 0,6 bis 0,95 vorliegt, und eine Gamma-Phase aufweist, die in einer Fraktion von 0,05 bis 0,4 vorliegt, und einer Keramikzusammensetzung gebildet ist, die über dem Substrat aufgebracht ist, wobei die Keramikzusammensetzungsbeschichtung eine säulenförmige Mikrostruktur aufweist,
wobei die Gamma-Gamma-Prime-Haftvermittlerbeschichtung eine Zusammensetzung in Gew.-% aufweist, die aus 5,0 bis 18 % Chrom, 7,5 bis 12 % Aluminium, bis zu 15 % Kobalt, bis zu 10,0 % Tantal, bis zu 10 % Molybdän, bis zu 6, 0 % Rhenium, bis zu 5, 0 % Wolfram, bis zu 1, 0 % Yttrium, 0,06 bis 0,5% Hafnium, bis zu 0, 3 % Silicium und als Rest Nickel besteht.

2. Motorkomponente nach Anspruch 1, wobei das Substrat eine Brennkammerplatte ist.

3. Motorkomponente nach Anspruch 1, wobei das Substrat eine Brennstoffdüse ist.

4. Motorkomponente nach Anspruch 1, wobei das Substrat ein Trennwandhitzeschild ist.

5. Motorkomponente nach Anspruch 1, wobei die Gamma-Gamma-Prime-Haftvermittlerbeschichtung eine Gamma-Prime-Phase, die in einer Volumenfraktion von 0,7 bis 0,9 vorliegt, und eine Gamma-Phase aufweist, die in einer Fraktion von 0,1 bis 0,3 vorliegt.

6. Motorkomponente nach einem der vorangehenden Ansprüche, wobei die Keramikzusammensetzungsschicht ein Oxid umfasst, das ausgewählt ist aus der Gruppe bestehend aus Zirkonoxid, Cerdioxid, Hafniumdioxid und Gemischen davon, dotiert mit 2 Mol-% bis 50 Mol-% eines Dotanden, ausgewählt aus der Gruppe bestehend aus Yttrium, Indium, Scandium, Lanthan, Cer, Praseodym, Neodym, Promethium, Samarium, Europium, Gadolinium, Terbium, Dysprosium, Holmium, Erbium, Thullium, Ytterbium und Lutetium.

7. Verfahren zum Ausbilden einer Wärmedämmschicht, folgende Schritte umfassend:
Bereitstellen einer Komponente, ausgewählt aus der Gruppe bestehend aus einer Brennstoffkammerplatte, einem Trennwandhitzeschild und einer Brennstoffdüse;
Abscheiden einer ersten Schicht einer Gamma-Gamma-Prime-Haftvermittlerbeschichtung, wobei die Gamma-Gamma-Prime-Haftbeschichtung eine Gamma-Prime-Phase, die in einer Volumenfraktion von 0,6 bis 0,95 vorliegt, und eine Gamma-Phase aufweist, die in einer Fraktion von 0,05 bis 0,4 vorliegt, und einer Keramikzusammensetzung gebildet ist, auf der Komponente und wobei die Gamma-Gamma-Prime-Haftvermittlerbeschichtung eine Zusammensetzung in Gew.-% aufweist, die aus 5,0 bis 18 % Chrom, 7,0 bis 12 % Aluminium, bis zu 15 % Kobalt, bis zu 10,0 % Tantal, bis zu 10 % Molybdän, bis zu 6,0 % Rhenium, bis zu 5,0 % Wolfram, bis zu 1,0 % Yttrium, 0,06 bis 0,5 % Hafnium, bis zu 0,3 % Silicium und als Rest Nickel besteht; und Abscheiden einer Keramikzusammensetzungsschicht mithilfe einer physischen Elektronenstrahl-Gasphasenabscheidungtechnik, wobei der Schritt des Abscheidens der Keramikzusammensetzung Halten der Komponente in einer Kammer mit einem Druck von 1e-5 bis 1e-3 Torr (1,33 x 10⁻³ bis 133 Pa), Anlegen eines Sauerstoffteildrucks im Bereich von 1e-5 bis 1e-3 Torr (1,33 x 10⁻³ bis 133 Pa), Halten eines Elektronenstrahlstroms im Bereich von 1,0 bis 5,0 Ampere auf einem Quellmaterial, das in einem Schmelztiegel enthalten ist, Halten der Komponententemperatur im Bereich von 1800 Grad Fahrenheit bis 2100 Grad Fahrenheit (982 - 1149 °C), Einbringen eines Gussblocks des Quellmaterials in den Schmelztiegel bei einer Geschwindigkeit von 0,5 bis 2,0 Zoll pro Stunde (12,7 bis 51 mm pro Stunde) und Halten einer Abscheidungsgeschwindigkeit von 1,0 bis 5,0 Mikrozoll pro Sekunde (25, 4 bis 127 nm pro Sekunde) umfasst.

8. Verfahren nach Anspruch 7, wobei der Schritt des Abscheidens der ersten Schicht ferner Abscheiden der Gamma-Gamma-Prime-Haftvermittlerbeschichtung umfasst, wobei die Gamma-Gamma-Prime-Haftvermittlerbeschichtung eine Gamma-Prime-Phase, die in einer Volumenfraktion von 0,7 bis 0,9 vorliegt, und eine Gamma-Phase aufweist, die in einer Fraktion von 0,1 bis 0,3 vorliegt.

9. Verfahren nach Anspruch 7 oder 8, ferner umfassend Abscheiden der ersten Schicht, Verdichten der ersten Schicht durch Kalthämmern und Polieren der verdichteten ersten Schicht, wobei der Schritt des Verdichtens Diffundieren der ersten Schicht in einer Schutzatmosphäre, ausgewählt aus der Gruppe bestehend aus Argon und einem Vakuum, bei einer Temperatur im Bereich von 1800 bis 2000 Grad Fahrenheit (1093 °C) für 2,0 bis 10 und Verdichten der Beschichtung durch Kalthämmern umfasst.

10. Verfahren nach einem der Ansprüche 7 bis 9, wobei der Schritt des Bereitstellens der Komponente Bereitstellen einer Brennkammerplatte aus einer Einkristallsuperlegierung auf Nickelbasis umfasst.

11. Verfahren nach einem der Ansprüche 7 bis 10, wobei der Schritt des Abscheidens der Keramikzusammensetzungsschicht Abscheiden eines Oxids umfasst, das ausgewählt wird aus der Gruppe bestehend aus Zirkonoxid, Cerdioxid, Hafniumdioxid und Gemischen davon, dotiert mit 2 Mol-% bis 50 Mol-% eines Dotanden, ausgewählt aus der Gruppe bestehend aus Yttrium, Indium, Scandium, Lanthan, Cer, Praseodym, Neodym, Promethium, Samarium, Europium, Gadolinium, Terbium, Dysprosium, Holmium, Erbium, Thullium, Ytterbium und Lutetium.

## Revendications

1. Composant de moteur comprenant un substrat choisi dans le groupe consistant en un panneau de chambre de combustion, un bouclier thermique de cloison et une buse de carburant, ledit substrat étant formé d'un superalliage monocristallin, d'une couche d'accrochage métallique formée d'un revêtement d'apprêt gamma-gamma, ledit revêtement d'apprêt gamma-gamma ayant une phase d'apprêt gamma présente dans une fraction en volume de 0,6 à 0,95 et une phase gamma présente dans une fraction de 0,05 à 0,4, et un revêtement de composition céramique appliqué par-dessus ledit substrat, ledit revêtement de composition céramique ayant une microstructure colonnaire,
dans lequel ledit revêtement d'apprêt gamma-gamma a une composition en % en poids consistant en 5,0 à 18 % de chrome, 7,5 à 12 % d'aluminium, jusqu'à 15 % de cobalt, jusqu'à 10,0 % de tantale, jusqu'à 10 % de molybdène, jusqu'à 6,0 % de rhénium, jusqu'à 5,0 % de tungstène, jusqu'à 1,0 % d'yttrium, de 0,06 à 0,5 % de hafnium, jusqu'à 0,3 % de silicium, et le reste étant du nickel.

2. Composant de moteur selon la revendication 1, dans lequel ledit substrat est un panneau de chambre de combustion.

3. Composant de moteur selon la revendication 1, dans lequel ledit substrat est une buse de carburant.

4. Composant de moteur selon la revendication 1, dans lequel ledit substrat est un bouclier thermique de cloison.

5. Composant de moteur selon la revendication 1, dans lequel ledit revêtement d'apprêt gamma-gamma a une phase d'apprêt gamma présente dans une fraction en volume de 0,7 à 0,9 et une phase gamma présente dans une fraction de 0,1 à 0,3.

6. Composant de moteur selon l'une quelconque des revendications précédentes, dans lequel ladite couche de composition céramique comprend un oxyde choisi dans le groupe consistant en la zircone, l'oxyde de cérium, l'oxyde de hafnium, et leurs mélanges dopés avec de 2 % en mol à 50 % en mol d'un dopant choisi dans le groupe consistant en l'yttrium, l'indium, le scandium, le lanthane, le cérium, le praséodyme, le néodyme, le prométhium, le samarium, l'europium, le gadolinium, le terbium, le dysprosium, l'holmium, l'erbium, le thulium, l'ytterbium et le lutécium.

7. Procédé de formation d'un revêtement formant barrière thermique comprenant les étapes de :
fourniture d'un composant choisi dans le groupe consistant en un panneau de carburant de combustion, un bouclier thermique de cloison et une buse de carburant ;
dépôt d'une première couche d'un revêtement d'apprêt gamma-gamma, dans lequel ledit revêtement d'apprêt gamma-gamma a une phase d'apprêt gamma présente dans une fraction en volume de 0,6 à 0,95 et une phase gamma présente dans une fraction de 0,05 à 0,4 sur ledit composant, et dans lequel ledit revêtement d'apprêt gamma-gamma a une composition en % en poids consistant en de 5 à 18 % de chrome, de 7,0 à 12 % d'aluminium, jusqu'à 15 % de cobalt, jusqu'à 10,0 % de tantale, jusqu'à 10 % de molybdène, jusqu'à 6,0 % de rhénium, jusqu'à 5,0 % de tungstène, jusqu'à 1,0 % d'yttrium, de 0,06 à 0,5 % de hafnium, jusqu'à 0,3 % de silicium, et le reste étant du nickel ; et
dépôt d'une couche de composition céramique à l'aide d'une technique de dépôt physique en phase vapeur par faisceau d'électrons, ladite étape de dépôt de composition céramique comprenant le maintien dudit composant dans une chambre à une pression dans la plage de 1e-5 à 1e-3 Torr (1,33 x 10⁻³ à 133 Pa), l'application d'une pression d'oxygène partielle dans la plage de de 1e-5 à 1e-3 Torr (1,33 x 10⁻³ à 133 Pa), le maintien d'un courant de faisceau d'électrons dans la plage de 1,0 à 5,0 amps sur un matériau de source contenu dans un creuset, le maintien d'une température de composant dans la plage de 982 à 1 149 °C (1 800 degrés Fahrenheit à 2 100 degrés Fahrenheit), l'introduction d'un lingot dudit matériau de source dans ledit creuset à une cadence de 12,7 à 51 mm par heure (0,5 à 2,0 pouces par heure), et le maintien d'une cadence de dépôt de 25,4 à 127 nm par seconde (1,0 à 5,0 micropouces par seconde).

8. Procédé selon la revendication 7, dans lequel ladite première étape de dépôt de couche comprend en outre le dépôt dudit revêtement d'apprêt gamma-gamma avec la phase d'apprêt gamma présente dans une fraction en volume de 0,7 à 0,9 et la phase gamma est présente dans une fraction de 0,1 à 0,3.

9. Procédé selon la revendication 7 ou 8, comprenant en outre le dépôt de ladite première couche, la densification de la première couche par martelage, et le polissage de la première couche densifiée, ladite étape de densification comprenant la diffusion de la première couche dans une atmosphère protectrice choisie dans le groupe consistant en l'argon et un vide à une température de 1 093 °C (dans la plage de 1 800 à 2 000 degrés Fahrenheit) pendant 2,0 à 10 heures, et la densification du revêtement par martelage.

10. Procédé selon l'une quelconque des revendications 7 à 9, dans lequel ladite étape de fourniture de composant comprend le fait de fournir un panneau de chambre de combustion formé d'un superalliage à base de nickel monocristallin.

11. Procédé selon l'une quelconque des revendications 7 à 10, dans lequel ladite étape de dépôt de couche de composition céramique comprend le dépôt d'un oxyde choisi dans le groupe consistant en la zircone, l'oxyde de cérium, l'oxyde de hafnium, et leurs mélanges dopés avec de 2 % en mol à 50 % en mol d'un dopant choisi dans le groupe consistant en l'yttrium, l'indium, le scandium, le lanthane, le cérium, le praséodyme, le néodyme, le prométhium, le samarium, l'europium, le gadolinium, le terbium, le dysprosium, l'holmium, l'erbium, le thulium, l'ytterbium et le lutécium.
